# EUROPÄISCHE PATENTSCHRIFT

(11) **EP 0 886 374 B1**
(45) Veröffentlichungstag und Bekanntmachung des Hinweises auf die Patenterteilung: **30.07.2003**
(21) Anmeldenummer: 98105898.5
(22) Anmeldetag: 31.03.1998
(51) Int. Cl.: H03G 11/02

(54) **Absorbierender Amplitudenbegrenzer**
Absorbing amplitude limiter
Limiteur absorbeur d'amplitudes

(30) Priorität: 19.06.1997 DE 19726070
(43) Veröffentlichungstag der Anmeldung: 23.12.1998
(73) Patentinhaber: EADS Deutschland GmbH, 81663 München (DE)
(72) Erfinder: Lampel, Peter, 85716 Unterschleissheim (DE)
(74) Vertreter: Meel, Thomas

(56) Entgegenhaltungen:
- US-A- 4 951 008
- US-A- 5 408 204

## Beschreibung

Die Erfindung betrifft einen absorbierenden Amplitudenbegrenzer gemäß dem Oberbegriff des Patentanspruchs 1.

Solche Amplitudenbegrenzer werden beispielsweise zum Schutz von empfindlichen Empfangsverstärkern (LNA, Low Noise Amplifier) für phasengesteuerte Antennen eingesetzt. Die Empfangsverstärker in Sende-Empfangsmodulen, sogenannten T/R Modulen, müssen vor Signalen mit zu hoher Leistung geschützt werden. Die Sende- und damit auch die Empfangs- HF-Frequenz liegen beispielsweise im X-Band. Es werden Durchschnittsleistungen von einem Watt und Spitzenleistungen von 10 Watt von einem Sendeverstärker (HPA, High Power Amplifier) zur Verfügung gestellt. Entsprechend hohe Empfangssignale können am Eingang des Empfangsverstärkers anliegen.

Für die Amplitudenbegrenzer gibt es drei verschiedene Betriebsmoden.
- Der Durchgangsmode (Low Insertion Loss Receive Mode) liegt beim Empfang schwacher Signale vor.
- Der Begrenzungsmode (High Insertion Loss Receive Mode) liegt beim Empfang von Signalen mit hoher Leistung vor.
- Der Sperrmode (Isolation Mode) ist von außen durch ein Steuersignal wählbar. Er dient zum Trennen des Empfangsverstärkers von der Antenne.

Entscheidend ist bei einem absorbierenden Amplitudenbegrenzer, daß im Begrenzungs- und im Sperrmode das empfangene Signal im Begrenzer absorbiert wird, und nicht zum Eingang der Schaltung zurück reflektiert wird.

Es sind zwei Möglichkeiten denkbar, einen solchen absorbierenden Begrenzer zu realisieren. Grundlage für beide Fälle ist ein sogenannter reflektierender Amplitudenbegrenzer, der aus einer λ/4-Leitung und vorzugsweise zwei PIN-Dioden besteht. Die beiden PIN-Dioden sind eingangs- und ausgangsseitig jeweils gegen ein Bezugspotential geschaltet.

In einem ersten Fall wird vor den Eingang des reflektierenden Begrenzers ein Zirkulator geschaltet, an dessen ersten Eingang die Antenne, und an dessen zweiten Eingang der Empfangsverstärker über den Begrenzer angeschaltet sind. Der dritte Anschluß des Zirkulators ist mit einem Lastwiderstand abgeschlossen. Dieser Lastwiderstand absorbiert das reflektierte Signal.

In einem zweiten Fall wird mit Hilfe eines ersten Leistungsteilers das empfangene Signal vorzugsweise in zwei gleiche Teile aufgeteilt, und am Ausgang mit einem zweiten Leistungsteiler wieder zusammengefaßt. Zwischen den beiden Leistungsteilern befinden sich zwei reflektierenden Amplitudenbegrenzer. Im Durchgangsmode durchlaufen beide Teilsignale den Begrenzer ungestört. Im Begrenzungs- und im Sperrmode werden die beiden Teilsignale des Empfangssignales mit einer Phasendifferenz von 180 Grad reflektiert. Hierdurch wird keine Signalleistung zum Eingang der Schaltung zurückreflektiert.

Der Erfindung liegt die Aufgabe zugrunde, einen besonders aufwandsarm, insbesondere hinsichtlich des Platzbedarfs, zu realisierenden Begrenzer anzugeben.

Diese Aufgabe wird erfindungsgemäß durch die im Patentanspruch 1 angegebenen Merkmale gelöst.

Der besondere Vorteil der erfindungsgemäßen Schaltung ist die Platz-, Gewichts- und Bauteileeinsparung. Im Vergleich zu Fall 1 kann der Zirkulator entfallen, was zu einer Gewichtsund Kosteneinsparung führt. Gegenüber Fall 2 entfallen die beiden Leistungsteiler, was zu einer Kosten- und Platzeinsparung führt.

Im folgenden wird die Erfindung anhand eines in der Zeichnung dargestellten Ausführungsbeispieles beschrieben. Dabei zeigen:
- Figur 1: eine Sende- Empfangsschaltung für eine phasengesteuerte Antenne, und
- Figur 2: den erfindungsgemäß ausgebildeten absorbierenden Amplitudenbegrenzer.

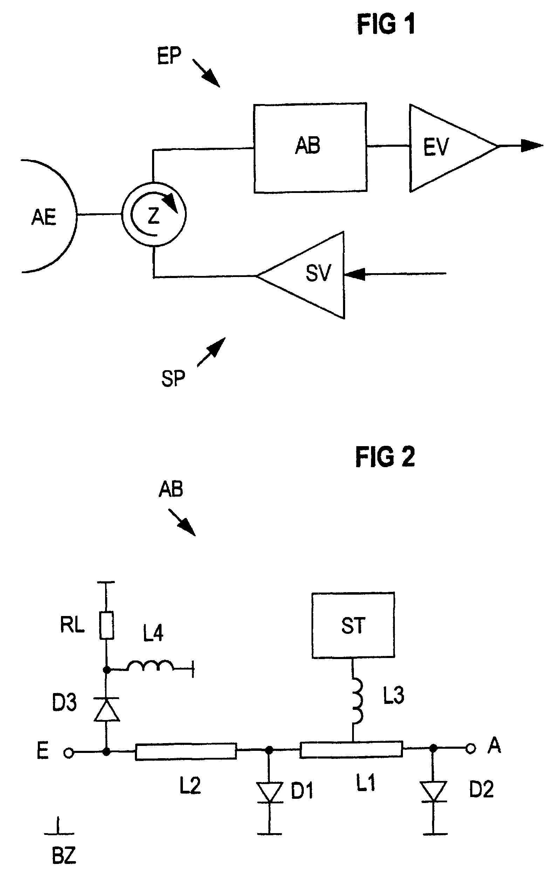

Ein in Figur 1 dargestelltes Sende- Empfangsmodul weist einen Sendepfad SP und einen Empfangspfad EP auf. Der Sendepfad SP und der Empfangspfad EP sind an zwei Eingängen eines Zirkulators Z angeschaltet, an dessen dritten Eingang ein Antennenelement beziehungsweise ein Strahlerelement AE angeschlossen ist. Im Sendepfad SP ist ein Sendeverstärker SV vorgesehen. Das empfangene Signal gelangt im Empfangspfad EP über einen Amplitudenbegrenzer AB zu einem Empfangsverstärker EV.

In Figur 2 ist der absorbierende Amplitudenbegrenzer AB dargestellt.

Dieser Amplitudenbegrenzer AB weist eine λ/4-Leitung L1 auf, die zwischen eine Eingangsklemme E und eine Ausgangsklemme A geschaltet ist. Das eingangsseitige Ende des Leiters L1 ist über eine PIN-Diode D1 und das ausgangsseitige Ende des Leiters L1 ist über eine PIN-Diode D2 mit einem Bezugspotential BZ verbunden. Der Leiter L1 ist weiter über eine HF-Sperre L3 mit einer Steuerung ST verbunden.

Diese Schaltungsteile stellen einen an sich bekannten reflektierenden Amplitudenbegrenzer dar, der zusätzlich über die Steuerung ST zwischen einem Durchgangs- und einem Sperrmode umschaltbar ist. Ein einfacher reflektierender Begrenzer schaltet automatisch, in Abhängigkeit von der Leistung des Eingangssignales, zwischen dem Durchgangs- und dem Begrenzungsmode um. Bei einer Erweiterung dieses Begrenzers wird durch eine Steuerspannung von außen ein Sperrmode eingestellt.

Erfindungsgemäß wird dieser reflektierende Begrenzer durch eine weitere Diode D3, beispielsweise ebenfalls eine PIN-Diode, eine weitere λ/4-Leitung L2, einen Lastwiderstand RL und eine weitere HF-Sperre L4 zu einem absorbierenden Begrenzer erweitert.

Die λ/4-Leitung L2 ist zwischen die Eingangsklemme E und das eingangsseitige Ende der Leitung L1 geschaltet. Das eingangsseitige Ende der Leitung L2, das heißt die Eingangsklemme E, ist über eine Reihenschaltung aus der Diode D3 und dem Lastwiderstand RL mit dem Bezugspotential BZ verbunden. Ein Punkt zwischen der Diode D3 und dem Lastwiderstand RL ist über die HF-Sperre L4 mit dem Bezugspotential BZ verbunden.

Hierdurch wird das empfangene Signal an der Eingangsklemme E im Durchgangsmode zur Ausgangsklemme A, im Begrenzungs- und im Sperrmode auf den Lastwiderstand RL geleitet.

Bei Eingangssignalen mit einer geringen Leistung sind die Dioden D1, D2 und D3 hochohmig, und das Eingangssignal erreicht die Ausgangsklemme A mit nur geringen Verlusten.

Durch eine, von der Steuerung ST abgegebene positive Spannung, oder durch ein Eingangssignal mit hoher Leistung an der Eingangsklemme E, werden die beiden Dioden D1 und D2 in einen niederohmigen Zustand gebracht. Eine niederohmig geschaltete Diode D1 bewirkt einen hohen Eingangswiderstand für HF-Signale am eingangsseitigen Ende des Leiters L2.

Bei niederohmig geschalteten Dioden D1 und D2 wird das HF-Eingangssignal reflektiert. Die Diode D3 ist zwar für das HF-Signal in Reihe mit dem Lastwiderstand RL geschaltet, für eine Gleichspannung ist sie jedoch parallel zum Lastwiderstand RL gegen das Bezugspotential Bz geschaltet. Dadurch wird auch die Diode D3 niederohmig. Die geringe Impedanz der Diode D1 wird durch die Leitung L2 in der Bezugsebene der Diode D3 auf eine hohe Impedanz transformiert. Dadurch wird das Eingangssignal über die Diode D3 auf den Lastwiderstand RL geleitet, wo es absorbiert wird.

## Patentansprüche

1. Absorbierender Amplitudenbegrenzer (AB) für HF-Signale mit einem reflektierenden Begrenzer, der insbesondere durch eine λ/4-Leitung (L1) und eine eingangsseitig und eine ausgangsseitig, jeweils gegen ein Bezugspotential (BZ) geschaltete Diode (D1, D2) realisiert ist, und
mit einer Absorptionsschaltung, die einen Lastwiderstand (RL) aufweist,
**dadurch gekennzeichnet, daß**
die Absorptionsschaltung eine, dem Begrenzer vorgeschaltete weitere λ/4-Leitung (L2) aufweist, die eingangsseitig eine, aus einer weiteren Diode (D3) und dem Lastwiderstand (RL) bestehende Reihenschaltung aufweist, die mit dem Bezugspotential (BZ) verbunden ist, wobei parallel zum Lastwiderstand (RL) eine HF-Sperre (L4) geschaltet ist.

2. Amplitudenbegrenzer (AB) nach Anspruch 1,
**dadurch gekennzeichnet, daß**
eine Steuerung (ST) über eine zusätzliche HF-Sperre (L3) mit dem reflektierenden Begrenzer verbunden ist, so daß der Amplitudenbegrenzer (AB) zwischen einem Durchgangs- und einem Sperrmode umschaltbar ausgebildet ist.

## Claims

1. Absorbing amplitude limiter (AB) for RF signals, having a reflecting limiter which is implemented, in particular, by a λ/4 line (L1) and diodes (D1, D2) which are respectively connected on the input and output sides of the reference potential (BZ), and having an absorption circuit which has a load resistor (RL), **characterized in that** the absorption circuit has a further λ/4 line (L2) which is connected upstream of the limiter and has on the input side a series circuit which consists of a further diode (D3) and the load resistor (RL) and is connected to the reference potential (BZ), an RF latch (L4) being connected in parallel with the load resistor (RL).

2. Amplitude limiter (AB) according to Claim 1, **characterized in that** a controller (ST) is connected to the reflecting limiter via an additional RF latch (L3) such that the amplitude limiter (AB) is constructed in a fashion capable of switching over between a low insertion loss receive mode and an isolation mode.

## Revendications

1. Limiteur absorbeur d'amplitude (AB) pour des signaux HF avec un limiteur réfléchissant, qui est réalisé en particulier par une ligne quart d'onde λ/4 (L1) et des diodes (D1, D2) raccordées respectivement du côté de l'entrée et du côté de la sortie à un potentiel de référence (BZ), et avec un circuit d'absorption, qui présente une résistance de charge (RL), **caractérisé en ce que** le circuit d'absorption présente une autre ligne quart d'onde λ/4 (L2) montée avant le limiteur, qui présente du côté de l'entrée un circuit en série composé d'une autre diode (D3) et de la résistance de charge (RL), et qui est relié au potentiel de référence (BZ), dans lequel une bobine de blocage de HF (L4) est montée en parallèle avec la résistance de charge (RL).

2. Limiteur d'amplitude (AB) selon la revendication 1, **caractérisé en ce qu'**une commande (ST) est raccordée au limiteur réfléchissant par l'intermédiaire d'une bobine de blocage de HF supplémentaire (L3), de telle façon que le limiteur d'amplitude (AB) puisse être commuté entre un mode de passage et un mode de blocage.
